# EUROPEAN PATENT SPECIFICATION

(11) **EP 1 936 960 B1**
(45) Date of publication and mention of the grant of the patent: **16.09.2015**
(21) Application number: 07123853.9
(22) Date of filing: 20.12.2007
(51) Int. Cl.: H03G 1/00, H04N 21/426, H01L 27/02, H03G 3/30, H04N 5/44, H04N 5/52

(54) **Signal processing system and method**
Signalverarbeitungssystem und zugehörige Methode
Système et procédé de traitement de signal

(30) Priority: 22.12.2006 CN 200610168690
(43) Date of publication of application: 25.06.2008
(73) Proprietor: Realtek Semiconductor Corp., Hsinchu 300 (TW)
(72) Inventor: Huang, Ching Her, 300 Hsinchu (TW); Chen, Jackson, 300 Hsinchu (TW)
(74) Representative: Lang, Christian

(56) References cited:
- EP-A- 0 792 015
- US-A- 5 270 824
- US-A1- 2005 130 617
- CROFT G ET AL: "ESD protection techniques for high frequency integrated circuits" MICROELECTRONICS AND RELIABILITY, ELSEVIER SCIENCE LTD, GB, vol. 38, no. 11, 1 November 1998 (1998-11-01), pages 1681-1689, XP002303830 ISSN: 0026-2714

## Description

### BACKGROUND OF THE INVENTION

### Field of the invention

The present invention relates to a signal processing system, and more particularly, to a signal processing system utilized in a DVB system.

### Description of the Related Art

In a digital TV system, many advantages are caused as the video and audio data are transferred in a digital form. For example, using the same bandwidth, the digital TV system can have larger data throughput to provide a better image resolution and better audio qualities. Furthermore, the programs of the digital TV can be stored as digital data. Therefore, the user can view the programs in demands.

In addition, because the digital TV system transfers data in a digital way, the data can be transferred via network lines. Therefore, the digital TV system is able to perform some functions of the internet and not limited to a basic function of a TV.

However, presently, the digital and analog signals both occupy some transmission bandwidths. When the mixed signals are received, one of the digital and analog signals may become noises of the other. For example, in the case that the digital TV signals share some bandwidths with other analog signals (e.g: FM signals), when the signals are received and analyzed, the FM signals will become noises of the digital TV signals. Therefore, the signal receiver is required to have a predetermined sensitivity such that the signal receiver can receive the signal (such as the digital TV signal) successfully. As is known, a dynamic receiving range represents the available power range of the receiver can offer.

EP 0 792 015 A2 relates to a radio selective call receiver capable of adjusting radio signal level. Said radio selective call receiver includes an attenuation circuit and a signal processing module comprising an amplifier, a frequency converter and a demodulator. The attenuation circuit is driven by an attenuation circuit control signal. US 2005/130617 A1 refers to a processing system for TV signals with an amplifier part and a signal processing module comprising tuners and demodulators. G. Croft and J. Bernier describe in "ESD protection techniques for high frequency integrated circuit" (Micro electronics Reliability, ELSEVIER SCIENCE LTD, GB, vol. 38, no. 11, November 1, 1998, pages 1681 to 1689, XP002303830, ISSN: 0026-2714) several techniques that have been used to protect integrated circuits without significantly degrading their AC operating performance from electrostatic discharge.

US 5,270,824 A describes an automatic gain control system including a quadrature coupler that has four ports, wherein two of said ports are terminated by pin diodes. The pin diodes are driven conductive in response to an automatic gain control voltage and control the power transfer from a first mixer to a first intermediate frequency amplifier.

### SUMMARY OF THE INVENTION

In view of the above-mentioned problems, an object of the invention is to provide a signal processing system having a better sensitivity and having a better performance when receiving a signal having low power. This object is solved by the signal processing system according to claim 1 and the signal processing method according to claim 5.

Advantageous improvements of the invention are subject matter of the corresponding dependent claims.

The present invention signal processing system has a better dynamic receiving range (sensitivity), and has a better performance when receiving a signal having low power. Furthermore, the present invention attenuator can be implemented by two diodes, which are originally embodied inside the signal processing system as an ESD circuit. This means that the present invention signal processing system can achieve the purpose without more costs.

### BRIEF DESCRIPTION OF THE DRAWINGS

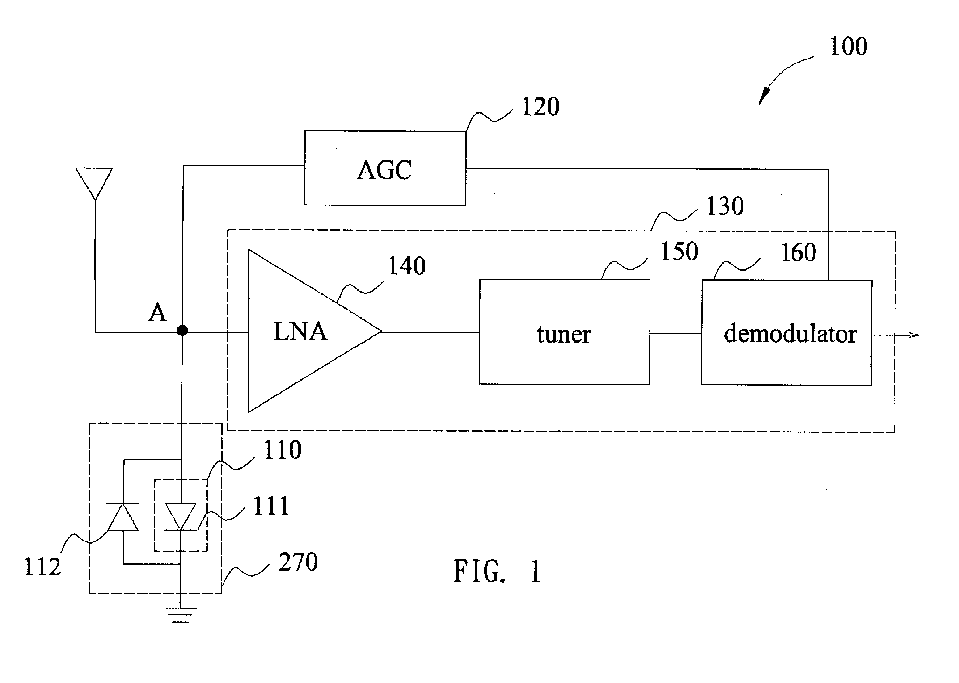

Fig.1 is a block diagram of a DVB signal processing system according to the present invention.

### DETAILED DESCRIPTION OF THE INVENTION

Please refer to Fig.1, which is a block diagram of a DVB signal processing system 100 according to the present invention. As shown in Fig.1, the signal processing system 100 comprises an attenuation module 110, an automatic gain controller (AGC) 120, and a signal processing module 130. In this embodiment, the signal processing module 130 comprises a low noise amplifier 140, a tuner 150, a demodulator 160, and an ESD circuit 270. The electrical connections among the above-mentioned components are shown in Fig.1, and thus omitted here.

As mentioned previously, the low noise amplifier 140 is utilized for amplifying the signal in a receiving band and for attenuating the signal outside the receiving band, to raise the signal-to-noise ratio. Therefore, the LNA 140 allows the signal processing system 100 to receive the signal having lower power to increase the dynamic receiving range of the signal processing system 100.

The tuner 150 is utilized to select a digital TV program. In other words, the tuner 150 receives the information carried by a specific channel and provides a specific gain to the signals. Then, the tuner 150 may transfer the processed signal (such as an MF signal) to the following demodulator 160.

At last, the demodulator 160 demodulates the information (signals) transferred from the tuner 150 to derive a baseband signal, in which the transport stream carried by the baseband signal is thus obtained.

Please note, the operations and functions of the LNA 140, the tuner 150, and the demodulator are well known, and thus omitted here for brevity.

In addition, as is known, the original function of the AGC 120 is to provide a DC voltage level according to the power of the received signal to the inner active circuits (such as the inner amplifiers or mixers) of the demodulator 160 such that the inner active circuits can provide an appropriate gain value. In this way, the demodulator 160 maintains the received signals (information) in a predetermined signal power such that the demodulator 160 can operate correctly.

Instead of the above-mentioned mechanism, the AGC 120 provides a gain to the MF signal such that the MF signal received by the demodulator 160 can have the aforementioned appropriate power. However, these changes both obey the scope of the present invention.

In another embodiment of the present invention, the AGC 120 is coupled to the tuner 150 instead of the demodulator 160. In this configuration, the AGC 120 provides the gain according to the power of the RF signal received by the tuner such that the signal power of the MF signal outputted by the tuner 150 have an appropriate power. This change also belongs to the scope of the present invention.

In the present invention, the AGC 120 provides different DC voltage levels according to different signal powers, to determine the DC voltage level of the node A.

As shown in Fig.1, the attenuation module 110 comprises a diode 111. Please note, the diode 111 is coupled between the ground voltage1 and the node A. Therefore, the configuration of the diode 111 and the signal processing module 130 is parallel.

In this embodiment, if the signal power is higher than a predetermined threshold (for example, the signal power is high enough to make the inner devices saturated), then the AGC 120 sets the DC level of the node A as a high voltage level. Therefore, the diode 111 is turned on, and some of the RF signals are transferred to the ground. In this way, the signal power 150 is therefore reduced. This means that the received signal is attenuated.

On the other hand, if the signal power is not higher than the predetermined threshold, then the AGC 120 sets the DC level of the node A as a low voltage level (such as a ground level). Therefore, the diode 111 is turned off and the RF signal can be completely transferred to the tuner 150.

Please note, as the diode 111 and the signal processing module 130 are connected in parallel, the RF signal is attenuated only when the power of the RF signal is too high. On the other hand, if the power of the RF signal is in an acceptable range, the RF signal is not influenced by the diode 111 and directly transferred to the signal processing module 130. Therefore, in this embodiment, it can be seen that the diode 111 does not generate additional noises because the signal does not pass through the diode. The diode 111 can raise the dynamic receiving range without ruining the performance of processing the signals having low power.

Furthermore, as shown in Fig.1, the signal processing system 100 further comprises the ESD circuit 270. As is known, the ESD circuit 270 is often established inside the signal processing system 100, and the frequently-used ESD circuit comprises two diodes 111 and 112, which are coupled inversely. Therefore, if the signal power is too high (for example, the negative or positive voltage is too high), one of the diodes 111 and 112 can be turned on to perform a discharging operation.

In this embodiment, the ESD circuit 270 and the attenuation module 110 share a common diode 111. In other words, the present invention does not need to spend more costs to establish an additional diode as an attenuator. For example, for a signal processing system originally having an ESD circuit 270, the present invention can directly utilize the AGC 120 to make the diode 111 have another function (attenuation). Therefore, the purpose of attenuation is achieved without increasing the costs.

In the above disclosure, the present invention is utilized in a DVB receiver. However, the scope of the present invention is not limited to the above-mentioned embodiments. In the actual implementation, the concept of the present invention can be utilized in all kinds of the system processing systems or system receiving systems.

In addition, the DC voltage level of the node A is controlled by the AGC. However, the scope of the present invention is not limited to the above-mentioned embodiments. In the actual implementation, the present invention can utilize any other circuits capable of determining the DC level of the node A according to the signal power of the input signal (such as a DC level generator). This change also obeys the scope of the present invention.

In contrast to the prior art, the present invention signal processing system has a better dynamic receiving range (sensitivity), and has a better performance when receiving a signal having low power. Furthermore, the present invention attenuator can be implemented by two diodes, which are originally embodied inside the signal processing system as an ESD circuit. This means that the present invention signal processing system can achieve the purpose without more costs.

While certain exemplary embodiments have been described and shown in the accompanying drawings, it is to be understood that such embodiments are merely illustrative , and that this invention should not be limited to the specific construction and arrangement shown and described with respect to Fig. 1, since various other modifications may occur to those ordinarily skilled in the art.

## Claims

1. A signal processing system comprising:
an attenuation module (110), for selectively performing an attenuation operation on a received signal according to an amplitude of the received signal to generate an attenuation signal, wherein the attenuation module (110) comprises a diode (111) coupled to ground;
a signal processing module (130), coupled in parallel to the attenuation module (110) , for receiving the attenuation signal and performing a signal processing operation on the attenuation signal, wherein the diode (111) of the attenuation module (110) is coupled to the signal processing module (130) through a node;
an automatic gain controller (120), for determining a voltage level of said node according to the amplitude of the received signal to selectively turn on the diode (111); and
an electrostatic discharge (ESD) protection circuit (270) for performing an ESD protection, wherein the ESD protection circuit (270) comprises a first diode (111) and a second diode (112) which are coupled inversely, wherein the first diode (111) is used as the diode of the attenuation module (110).

2. The signal processing system of claim 1, wherein when the amplitude of the received signal is larger than a predetermined threshold, the voltage determining module sets the voltage level of the node as a high voltage level to turn on the diode.

3. The signal processing system of claim 1, wherein when the amplitude of the received signal is less than a predetermined threshold, the voltage determining module sets the voltage level of the node as a low voltage level to turn off the diode.

4. The signal processing system of claim 1, being utilized in a digital video broadcast (DVB) receiver.

5. A signal processing method comprising:
selectively performing an attenuation operation on a received signal according to an amplitude of the received signal to generate an attenuation signal by an attenuation module (110) comprising a diode (111) coupled to ground;
receiving the attenuation signal and performing a signal processing operation on the attenuation signal in a signal processing module (130) coupled in parallel to the attenuation module (110), wherein the diode (111) of the attenuation module (110) is coupled to the signal processing module (130) through a node; determining a voltage level of said node according to the amplitude of the received signal to selectively turn on the diode (111) such that the attenuation operation is selectively performed on the received signal; and
performing an electrostatic discharge (ESD) protection by an ESD protection circuit (270), wherein the ESD protection circuit (270) comprises a first diode (111) and a second diode (112) which are coupled inversely, wherein the first diode (111) is used as the diode of the attenuation module (110).

6. The signal processing method of claim 5, wherein the step of generating the attenuation signal comprises:
when the amplitude of the received signal is larger than a predetermined threshold, setting the amplitude of the node as a high voltage level to turn on the diode.

7. The signal processing method of claim 5, wherein the step of generating the attenuation signal comprises:
when the amplitude of the received signal is lower than a predetermined threshold, setting the amplitude of the node as a low voltage level to turn off the diode.

8. The signal processing method of claim 5 being utilized in a digital video broadcast (DVB) receiver.

## Patentansprüche

1. Signalverarbeitungssystem umfassend:
ein Dämpfungsmodul (11), zum selektiven Durchführen einer Dämpfungsoperation an einem empfangenen Signal entsprechend einer Amplitude des empfangenen Signals, um ein Dämpfungssignal zu erzeugen, wobei das Dämpfungsmodul (110) eine Diode (111) umfasst, die mit Erde verbunden ist;
ein Signalverarbeitungsmodul (130), das mit dem Dämpfungsmodul (110) parallel verschaltet ist, um das Dämpfungssignal (11) zu empfangen und eine Signalverarbeitungsoperation an dem Dämpfungssignal (11) durchzuführen, wobei die Diode (111) des Dämpfungsmoduls (110) mit dem Signalverarbeitungsmodul (130) über einen Knoten verbunden ist;
einen automatischen Verstärkungsregler (120), für das Bestimmen eines Spannungsniveaus des besagten Knotens entsprechend der Amplitude des empfangenen Signals, um selektiv die Diode (111) anzuschalten; und
einen elektrostatischen Entladungs-(ESD)-Schutzschaltkreis (270), zum Durchführen eines ESD-Schutzes, wobei der ESD-Schutzschaltkreis (270) eine erste Diode (111) und eine zweite Diode (112) umfasst, welche invers verbunden sind, wobei die erste Diode (111) als die Diode des Dämpfungsmoduls (110) verwendet wird.

2. Signalverarbeitungssystem nach Anspruch 1, wobei, wenn die Amplitude des empfangenen Signals größer als ein vordefinierter Grenzwert ist, das Spannungsbestimmungsmodul das Spannungsniveau des Knotens als ein Hochspannungsniveau setzt, um so die Diode anzuschalten.

3. Signalverarbeitungssystem nach Anspruch 1, wobei wenn die Amplitude des empfangenen Signals niedriger als ein vordefinierter Grenzwert ist, das Spannungsbestimmungsmodul das Spannungsniveau des Knotens als ein Niederspannungsniveau setzt, um so die Diode abzuschalten.

4. Signalverarbeitungssystem nach Anspruch 1, wobei das Signalverarbeitungssystem in einem digitalen Videorundfunkempfänger (DVB) verwendet wird.

5. Signalverarbeitungsverfahren umfassend:
selektives Durchführen einer Dämpfungsoperation an einem empfangenen Signal entsprechend einer Amplitude des empfangenen Signals, um durch ein Dämpfungsmodul (110) ein Dämpfungssignal zu erzeugen, wobei das Dämpfungsmodul (110) eine Diode (111) umfasst, die mit Erde verbunden ist;
Empfangen des Dämpfungssignals (11) und Durchführen einer Signalverarbeitungsoperation an dem Dämpfungssignal (11) in einem Signalverarbeitungsmodul (130), das mit dem Dämpfungsmodul (110) parallel verschaltet ist, wobei die Diode (111) des Dämpfungsmoduls (110) mit dem Signalverarbeitungsmodul (130) über einen Knoten verbunden ist;
Bestimmen eines Spannungsniveaus des besagten Knotens entsprechend der Amplitude des empfangenen Signals, um selektiv die Diode (111) anzuschalten, sodass die Dämpfungsoperation selektiv an dem empfangenen Signal durchgeführt wird; und
Durchführen eines elektrostatische Entladungs-(ESD)-Schutzes durch einen ESD-Schutzschaltkreis (270), wobei der ESD-Schutzschaltkreis (270) eine erste Diode (111) und eine zweite Diode (112) umfasst, welche invers verbunden sind, wobei die erste Diode (111) als die Diode des Dämpfungsmoduls (110) verwendet wird.

6. Signalverarbeitungsverfahren nach Anspruch 5, wobei der Schritt des Erzeugens des Dämpfungssignals umfasst:
Setzen der Amplitude des Knotens als ein Hochspannungsniveau, wenn die Amplitude des empfangenen Signals größer als ein vordefinierter Grenzwert ist, um so die Diode anzuschalten.

7. Signalverarbeitungsverfahren nach Anspruch 5, wobei der Schritt des Erzeugens des Dämpfungssignals umfasst:
Setzen der Amplitude des Knotens als ein Niederspannungsniveau, wenn die Amplitude des empfangenen Signals kleiner als ein vordefinierter Grenzwert ist, um so die Diode abzuschalten.

8. Signalverarbeitungsverfahren nach Anspruch 5, wobei das Signalverarbeitungsverfahren in einem digitalen Videorundfunkempfänger (DVB) verwendet wird.

## Revendications

1. Système de traitement de signal comprenant :
un module d'atténuation (110), pour effectuer de manière sélective une opération d'atténuation sur un signal reçu en fonction d'une amplitude du signal reçu pour générer un signal d'atténuation, dans lequel le module d'atténuation (110) comprend une diode (111) couplée à la masse ;
un module de traitement de signal (130), couplé en parallèle au module d'atténuation (110), pour recevoir le signal d'atténuation et effectuer une opération de traitement de signal sur le signal d'atténuation, dans lequel la diode (111) du module d'atténuation (110) est couplée au module de traitement de signal (130) par l'intermédiaire d'un noeud ;
un contrôleur automatique de gain (120), pour déterminer un niveau de tension dudit noeud fonction de l'amplitude du signal reçu pour activer de manière sélective la diode (111) ; et
un circuit de protection contre les décharges électrostatiques (ESD) (270) pour effectuer une protection contre les ESD, dans lequel le circuit de protection contre les ESD (270) comprend une première diode (111) et une seconde diode (112) qui sont couplées de manière inverse, dans lequel la première diode (111) est utilisée comme la diode du module d'atténuation (110).

2. Système de traitement de signal selon la revendication 1, dans lequel lorsque l'amplitude du signal reçu est supérieure à un seuil prédéterminé, le module de détermination de tension règle le niveau de tension du noeud en tant que niveau de tension élevé pour activer la diode.

3. Système de traitement de signal selon la revendication 1, dans lequel lorsque l'amplitude du signal reçu est inférieure à un seuil prédéterminé, le module de détermination de tension règle le niveau de tension du noeud en tant que niveau de tension bas pour désactiver la diode.

4. Système de traitement de signal selon la revendication 1, étant utilisé dans un récepteur de diffusion vidéo numérique (DVB).

5. Procédé de traitement de signal comprenant :
effectuer de manière sélective une opération d'atténuation sur un signal reçu en fonction d'une amplitude du signal reçu pour générer un signal d'atténuation par un module d'atténuation (110) comprenant une diode (111) couplée à la masse ;
recevoir le signal d'atténuation et effectuer une opération de traitement de signal sur le signal d'atténuation dans un module de traitement de signal (130) couplé en parallèle au module d'atténuation (110), dans lequel la diode (111) du module d'atténuation (110) est couplée au module de traitement de signal (130) par l'intermédiaire d'un noeud ;
déterminer un niveau de tension dudit noeud en fonction de l'amplitude du signal reçu pour activer de manière sélective la diode (111) de telle sorte que l'opération d'atténuation est effectuée de manière sélective sur le signal reçu; et
effectuer une protection contre les décharges électrostatiques (ESD) par un circuit de protection contre les ESD (270), dans lequel le circuit de protection contre les ESD (270) comprend une première diode (111) et une seconde diode (112) qui sont couplées de manière inverse, dans lequel la première diode (111) est utilisée comme la diode du module d'atténuation (110).

6. Procédé de traitement du signal selon la revendication 5, dans lequel l'étape consistant à générer le signal d'atténuation comprend :
lorsque l'amplitude du signal reçu est supérieure à un seuil prédéterminé, régler l'amplitude du noeud en tant que niveau de tension élevé pour activer la diode.

7. Procédé de traitement du signal selon la revendication 5, dans lequel l'étape consistant à générer le signal d'atténuation comprend :
lorsque l'amplitude du signal reçu est inférieure à un seuil prédéterminé, régler l'amplitude du noeud en tant que niveau de tension bas pour désactiver la diode.

8. Procédé de traitement de signal selon la revendication 5, étant utilisé dans un récepteur de diffusion vidéo numérique (DVB).
